# EUROPEAN PATENT APPLICATION

(11) **EP 2 892 078 A1**
(43) Date of publication of application: **08.07.2015**
(21) Application number: 14198158.9
(22) Date of filing: 16.12.2014
(51) Int. Cl.: H01L 25/16, H05K 1/18, F21V 23/00, H01L 33/48, F21Y 101/02

(54) **A lighting device and corresponding method**

(30) Priority: 30.12.2013 IT TO20131084
(71) Applicant: OSRAM GmbH, 80807 München (DE); Osram S.p.A. - Societa' Riunite Osram Edison Clerici, 20126 Milano (IT)
(72) Inventor: Zanotto, Alberto, I-35127 Padova (IT); Griffoni, Alessio, I-30030 Fossò (Venezia) (IT)
(74) Representative: Bosotti, Luciano

(57) **Abstract**

A lighting device comprises:
- one or more light radiation sources (18), e.g. LEDs,
- drive circuitry (20) for the light radiation source(s) (18), and
- a holder (10) having a front surface with the light radiation source(s) (10) and the drive circuitry (20) mounted thereon.

Said front surface has at least one relief portion (12a) and at least one recessed portion (12b).

The light radiation source(s) are mounted on the relief portion (12a) and the drive circuitry (20) is mounted in the recessed portion(s) (12b), a masking material (24) being provided to cover said drive circuitry (20) in said at least one recessed portion (12b). A layer of transparent material (26) is arranged to cover the light radiation source(s) (18) and the masking material (24).

## Description

### Technical field

The present disclosure relates to lighting devices.

One or more embodiments may refer to solid-state lighting devices which make use of LED (Light Emitting Diode) radiation sources as light radiation sources.

### Technological Background

Various embodiments of lighting devices may comprise:
- one or more electrically powered light radiation sources (e.g. LEDs),
- drive circuitry (20) for said light radiation source(s), and
- a holder with a front surface, with the light radiation source(s) and the drive circuitry mounted thereon.

For example in the case of LED flexible modules, the electrical and electronic components (LEDs, resistors, capacitors, drive circuitry or drivers etc.) may be mounted only on one side of a holder, which is provided for example on one face of the printed circuit board (PCB).

In these implementations, components are visible by the end user, and this fact can lead to various disadvantages.

For example, the choice of electrical and electronic components may be significantly limited. In the presence of a high number of resistors, capacitors, drive units etc., the radiation pattern may show an alternation of light and dark areas, with a consequent reduction in power efficiency and light uniformity.

This drawback may be partially countered by using small-sized electrical and electronic components, which may involve a less than optimal choice of components in terms of both cost and performance.

Moreover, limits may arise in the choice of the light radiation sources, such as LEDs: for example, one may wish to use LEDs which are "taller" than other components, which may lead however to a less than optimal choice in terms of performance, reliability and cost of the LEDs themselves.

The possible masking of darker components with a silicone layer of a light colour (e.g. a white colour which may be perceived as belonging to a whiteness scale) may impose strict tolerances in terms of process.

Various implementations may attempt to mitigate this problem through a process comprising two subsequent steps, i.e. the deposition of a layer, e.g. a silicone layer, of a light colour (e.g. white), followed by the deposition of a layer, e.g. another silicone layer, which is transparent (i.e. permeable to light).

In addition to the drawbacks related to the previously stated dimensional tolerances, this solution may lead to an intrinsic limitation of the spacing between sources (the so-called LED-to-LED pitch) due to the need of room for mounting other electrical and electronic components.

Another previously proposed solution involves the use of electrical and electronic components which, instead of having a dark colour (for example a black package, according to the current usage), are of a light colour. This solution may however impose constraints in terms of components supply, thus increasing the cost thereof.

### Object and Summary

One or more embodiments aim at overcoming the previously outlined drawbacks.

One or more embodiments achieve said object thanks to a lighting device having the features specifically set forth in the claims that follow.

One or more embodiments may also refer to a corresponding method.

The claims are an integral part of the technical teaching provided herein with reference to the invention.

One or more embodiments may use electrical lines which are directly printed on a holder, e.g. a silicone holder, with a general U-shape, by using for example the MID (Molded Interconnect Device) technology.

In one or more embodiments it is possible to print the electrical lines on a 3-D structure (for example a holder of a flexible material such as silicone), and not only on a 2-D surface.

In one or more embodiments it is possible to mount components not only in horizontal layers but also in vertical layers.

In one or more embodiments, this possibility is useful in order to be able to mount a high number of components, for example an ESD (ElectroStatic Discharge) protection device for each lighting source, e.g. for every LED.

In one or more embodiments, the possibility to mount components in all three dimensions leads to obtaining smaller-sized modules (e.g. "narrower" modules) in comparison with traditional technologies.

One or more embodiments enable to implement for example a lighting device as a so-called "flex" LED module with IP (Ingress Protection) grade, without the need to use a flexible PCB as a holder.

One or more embodiments lead to the achievement of one or more of the following advantages:
- reduction of the costs of the lighting device (module), as it is possible to omit a component such as a printed circuit board (PCB),
- reduction of the time for device development, also with reference to the raw material provision for PCBs,
- possibility to implement a new layout directly during the mounting process,
- in the final product, possibility to enable the visibility of the sole light radiation sources (e.g. LEDs),
- possibility to choose the light radiation sources within a wider range of available sources, with an improvement of cost efficiency, e.g. with reference to LEDs,
- possibility to obtain elongated modules (e.g. in the form of so-called "flex" modules),
- reduction of the LED-to-LED pitch.

### Brief description of the Figures

One or more embodiments will now be described, by way of non-limiting example only, with reference to the enclosed figures.

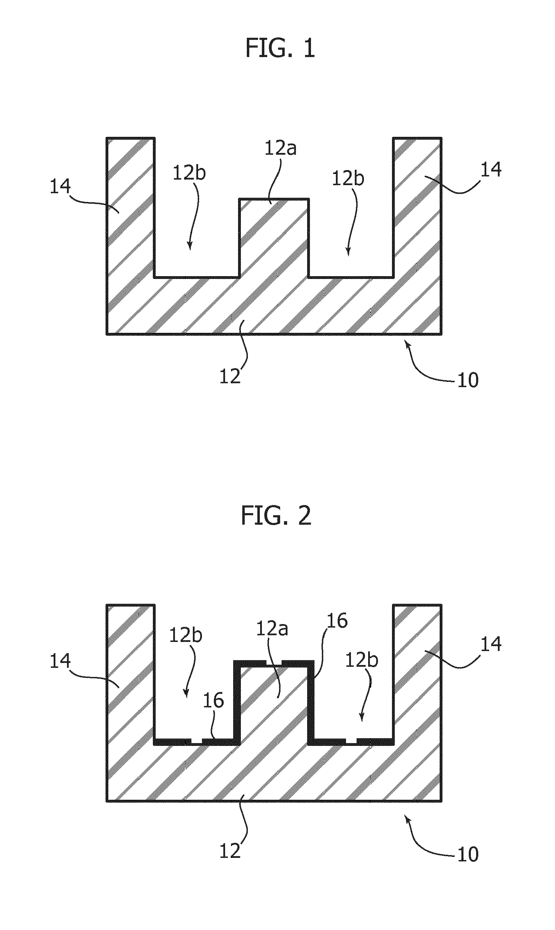

The Figures comprise five Figures denoted in sequence as Figure 1, Figure 2, Figure 3, Figure 4 and Figure 5, showing subsequent steps for achieving embodiments.

### Detailed Description

In the following description, numerous specific details are given to provide a thorough understanding of various exemplary embodiments. One or more embodiments may be practiced without one or more specific details, or with other methods, components, materials, etc. In other instances, well-known structures, materials, or operations are not shown or described in detail to avoid obscuring aspects of the embodiments. Reference throughout this specification to "an embodiment" means that a particular feature, structure, or characteristic described in connection with the embodiment is included in at least one embodiment. Thus, the possible appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The headings provided herein are for the reader's convenience only and do not interpret the scope or meaning of the embodiments.

In the Figures, reference 10 denotes a holder, that may be used to mount the electrically powered light radiation source(s) and the related drive circuitry of a lighting device, e.g. a solid-state lighting device such as a so called LED "module".

In one or more embodiment, holder 10 may be made of a flexible material such as, for example, silicone.

In one or more embodiments, the material of holder 10 may be a material of a light colour, e.g. a white colour, i.e. a colour adapted to be identified with a colour in the whiteness scale.

In one or more embodiments, holder 10 may be made of an elongated (e.g. band-shaped) body, which in Figures 1 to 5 is shown in cross section.

In one or more embodiments, holder 10 may have a U-shaped cross sectional profile (i.e. a profile which has, at least approximately, the shape of a channel), in which it is possible to discern a bottom wall 12 and two side walls 14 (having equal or different heights).

In one or more embodiments, bottom wall 12 comprises a central raised portion 12a, i.e. a relief portion as compared to two side portions 12b, which are recessed.

In one or more embodiments, the front surface of bottom wall 12 (in the presently shown examples, such a front surface is turned towards side walls 14a) may have a general "mesa" shape.

In one or more embodiments, in said front surface of holder 10 it is therefore possible to discern:
- at least a relief portion 12a, and
- at least a recessed portion 12b.

In one or more embodiments, a holder as exemplified in Figure 10 may be produced, e.g. by extrusion or molding, by using a material such as silicone.

In one or more embodiments, it is possible to produce a holder 10 having a general band shape, featuring flexibility along its length.

Figure 2 exemplifies the possibility to provide electrically conductive lines 16 on the front surface of holder 10.

In one or more embodiments, conductive lines 16 may be provided by resorting to the MID (Molded Interconnect Device) technology.

The MID technology is available in various implementations, e.g. according to solutions known as laser structuring, plasma structuring and aerosol-jetting.

Laser structuring solutions are available from various suppliers, e.g. with the trade names LPKF-LDS™ and ProtoPaint™ from LPKF Laser & Electronics AG . Osteriede 7 of 30827 Garbsen - Germany. Such technologies enable to provide circuit lines 16 directly on a holder 10 of a material such as silicone, e.g. with laser techniques.

The laser structuring technology Laser Direct Structuring (LDS) available from Molex of Lisle, IL 60532-1682, USA offers high precision features but requires to consider the cost and the choice of a suitable, e.g. silicone, material.

Plasma structuring solutions, such as Plasmadust™ available from Research Association 3-D MID e.V. of Nuremberg, Germany, or the aerosol-jetting technology available from Optomec of Albuquerque, NM 87109, USA, may be advantageous from the point of view of cost.

Whatever the specific solution adopted, the MID technology enables to provide conductive lines, such as those exemplified with 16 in the Figures, on a 3-D holder 10, for example with the U-profile exemplified in the annexed Figures.

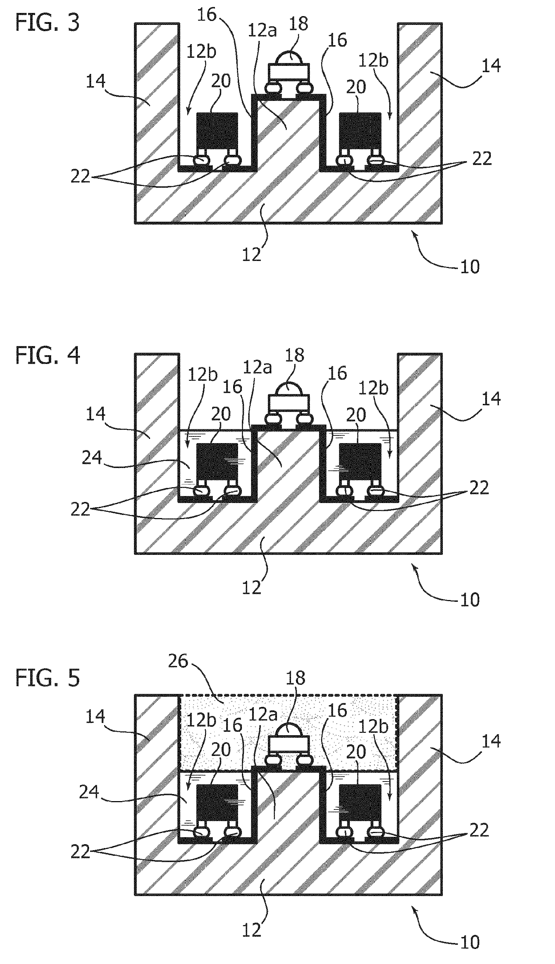

Figure 3 exemplifies the possibility to mount components on holder 10 by using the connectivity provided by electrically conductive lines 16.

For example, Figure 3 exemplifies the possibility of mounting:
- on the relief portion 12a of the front surface of holder 10, one or more electrically powered light radiation sources (e.g. LEDs) 18, and
- in the recessed portions 12b, drive circuits 20 (such as resistors, capacitors, drive units or drivers, etc.) associated to the source(s), denoted with 20.

The connection of one or more radiation sources 18 with the corresponding driving circuits 20 via lines 16 may therefore be achieved as exemplified in 22, e.g. through soldering or by using electrically conductive adhesives adapted to be cured, so as to ensure both the electrical connection and the mechanical fastening of components 18 and 20 on lines 16 and therefore on holder 12.

In one or more embodiments, light radiation source(s) 18 are therefore located in a raised position as compared to circuits 20, regardless of the specific size features of the source(s) 18. Therefore, the latter may be chosen with low height as well, which enables to widen the choice range of such light radiation sources with a positive effect, for example, on the production costs.

The drive circuitry 20 (adapted to have an overall dark colour, e.g. black, which may usually be associated with the related packages) may be located in the recessed portion(s) 12.

In this way, as exemplified in Figure 4, within recessed portion(s) 12b there may be located (e.g. cast) a masking material 24, e.g. a light coloured silicone (e.g. white silicone) having the function of a masking material, adapted to cover circuits 20 which are located in the portion (s) 12b in such a way as to mask them, making them no longer visible from the outside of the device when the latter is observed from the front, i.e. when observing the front surface on which the lighting source(s) 18 is/are located.

It will be appreciated that the representation provided in the annexed figures as regards the height or the thickness of the masking layer 24 is merely exemplary. For example, Figures 4 and 5 exemplify embodiments wherein layer 24 is flush with the relief portion 12a.

In one or more embodiments, layer 24 may reach as far as covering lines 16 below LED 18, enabling the electric connection thereof.

In one or more embodiments, the thickness or the height of the masking layer 24 may depend on the height of electrical/electronic components 20, adapted to be masked by layer 24. In one or more embodiments, the height of the electrical / electronic components 20 may reach as far as the LED package, represented in the Figures by the rectangle denoted by 18.

In one or more embodiments, as schematically shown in Figure 5, above masking material 24 it is then possible to apply a transparent coating/sealing material 26, that is permeable to light radiation.

In one or more embodiments, material 26 may extend also above the light radiation source(s) 18. Being permeable to light radiation, such a material allows the radiation emitted by source(s) to propagate outside device 10.

In one or more embodiments, material 26 may play a sealing role (e.g. with an IP protection) of components 18 and 20, by connecting sealingly with side walls 14 of holder 10.

Of course, without prejudice to the underlying principles of the invention, the details and the embodiments may vary, even appreciably, with respect to what has been described herein by way of non-limiting example only, without departing from the scope of the invention, said scope being defined by the annexed claims.

## Claims

1. A lighting device, including:
- at least one electrically powered light radiation source (18),
- drive circuitry (20) for said at least one light radiation source (18), and
- a holder (10) with a front surface with said at least one light radiation source (18) and said drive circuitry (20) mounted thereon,
wherein:
- said front surface includes at least one relief portion (12a) and at least a recessed portion (12a),
- said at least one light radiation source (18) is mounted on said at least one relief portion (12a),
- said drive circuitry (20) is mounted in said at least one recessed portion (12b), and
- a masking material (24) is provided covering said drive circuitry(20) in said at least one recessed portion (12b).

2. The lighting device of claim 1, including a layer of a light permeable material (26) covering said at least one light radiation source (18) and, preferably, said masking material (24) in said at least one recessed portion (12b).

3. The lighting device of claim 1 or claim 2, wherein at least one, and preferably both of said holder (10) and said masking material (24) have a light colour, preferably a white colour.

4. The lighting device of any of the previous claims, wherein said front surface has a mesa shape with a central relief portion (12a) flanked by two recessed portions (12b).

5. The lighting device of any of the previous claims, wherein said holder (10) is an elongated member, preferably of a flexible material.

6. The lighting device of any of the previous claims, wherein said holder (10) is U-shaped with a web wall (12) having a central relief portion (12a) and lateral recessed portion (12b).

7. The lighting device of any of the previous claims, including electrically conductive lines (16) realized by MID technology onto the front surface of said holder (10).

8. The lighting device of any of the previous claims, including electrically conductive lines (16) extending in a tri-dimensional pattern.

9. A method of producing a lighting device, including:
- providing at least one electrically powered light radiation source (18) and drive circuitry (20) for said at least one light radiation source (18),
- providing a holder (10) with a front surface for mounting said at least one light radiation source (18) and said drive circuitry (20), wherein said front surface includes at least one relief portion (12a) and at least a recessed portion (12a),
- mounting said at least one light radiation source (18) on said at least one relief portion (12a),
- mounting said drive circuitry (20) in said at least one recessed portion (12b), and
- providing a masking material (24) covering said drive circuitry (20) in said at least one recessed portion (12b).

10. The method of claim 9, including providing a layer of a light permeable material (26) covering said at least one light radiation source (18) and, preferably, said masking material (24) in said at least one recessed portion (12b).
